(19) Europäisches Patentamt
European Patent Office
Office européen des brevets

(11) **EP 1 528 667 B1**

(12) **EUROPEAN PATENT SPECIFICATION**

(45) Date of publication and mention
of the grant of the patent:
**19.12.2007 Bulletin 2007/51**

(51) Int Cl.:
*H03F 1/18* (2006.01)        *H03F 1/22* (2006.01)
*H03F 3/19* (2006.01)

(21) Application number: **04025774.3**

(22) Date of filing: **29.10.2004**

(54) **Variable amplifier and mobile wireless terminal using same**

Einstellbarer Verstärker und mobiles, schnurloses Endgerät mit einem solchen Verstärker

Amplificateur variable et terminal mobile sans fil comprenant un tel amplificateur

(84) Designated Contracting States:
**DE FR GB**

(30) Priority: **31.10.2003  JP 2003372674**

(43) Date of publication of application:
**04.05.2005  Bulletin 2005/18**

(73) Proprietor: **Sharp Kabushiki Kaisha**
**Osaka-shi, Osaka 545-8522 (JP)**

(72) Inventor: **Kawamura, Hiroshi**
**Kashihara-shi**
**Nara 634-0805 (JP)**

(74) Representative: **Müller - Hoffmann & Partner**
**Patentanwälte,**
**Innere Wiener Strasse 17**
**81667 München (DE)**

(56) References cited:
**US-A1- 2002 113 656        US-A1- 2003 048 133**
**US-B1- 6 400 227**

• **GILBERT B: "A Low-noise Wideband Variable-gain Amplifier Using An Interpolated Ladder Attenuator" SOLID-STATE CIRCUITS CONFERENCE, 1991. DIGEST OF TECHNICAL PAPERS. 38TH ISSCC., 1991 IEEE INTERNATIONAL SAN FRANCISCO, CA, USA 13-15 FEB. 1991, NEW YORK, NY, USA,IEEE, US, 13 February 1991 (1991-02-13), pages 280-281, XP010039694 ISBN: 0-87942-644-6**
• **PATENT ABSTRACTS OF JAPAN vol. 2000, no. 19, 5 June 2001 (2001-06-05) -& JP 2001 044776 A (SONY CORP), 16 February 2001 (2001-02-16)**

**Description**

FIELD OF THE INVENTION

The present invention relates to variable amplifiers offering variable overall characteristics including gain, linearity, and noise performance and relates also to mobile wireless terminals using such an amplifier with received signals.

BACKGROUND OF THE INVENTION

Mobile wireless terminals need to adopt to variable reception power and adjust transmission power. To address these needs, many variable gain amplifiers are used to vary gain.
Those variable gain amplifiers in receiver circuitry are required to reduce noise to a minimum and provide a large gain when the reception power is low. At high reception powers, they are required, among other things, to provide high linearity in order to prevent the high input power from distorting the output.
An example of a variable gain amplifier filling these requirements is disclosed in "A Low-Noise Wideband Variable-Gain Amplifier Using an Interpolated Ladder Attenuator," ISSCC Digest of Technical Papers, pp. 280-281, Feb. 1991 ("ISSCC Digest") and Technical Report of Signal Science, Vol. 96, No. 462, ED 96-198, pp. 9-14, 1997 ("Technical Report"). The variable gain amplifier achieves low noise at large gains and high linearity at small gains through a combined use of a set of amplifiers with identical characteristics and multiple stages of attenuators.
As can be seen in this example, the variable gain amplifier in mobile wireless terminal receiver circuitry is required to achieve a wide variation range, low noise, and high linearity. Differential circuitry may be used in a variable gain amplifier to attain these goals.
Another variable gain amplifier is disclosed in Japanese unexamined patent application 2002-252532 ("Tokukai 2002-252532"; published on September 6, 2002). The amplifier contains an input section and an output section. The input section contains a set of variable gain amplifier circuits, each exhibiting a decreasing gain with an increase in an external control voltage, connected in parallel. In each variable gain amplifier circuit, the emitters of the first and second transistors are connected to a constant current source and connected also to each other through an intervening emitter resistor. In response to an input signal, the first and second transistors output collector currents via their collectors. Receiving the collector current inputs from the input section, the output section produces output signals at a gain in accordance with the control voltage for output.
However, the variable gain amplifiers disclosed in the ISSCC Digest, the Technical Report, and Tokukai 2002-252532 are designed to operate on a differential input signal. They cannot be directly connected to a signal source of single-ended (unbalanced) signals. In other words, with a variable gain amplifier built into receiver circuitry, the antenna, which is the signal source for the variable gain amplifier, outputs single-ended signals. So, when building a conventional variable gain amplifier into receiver circuitry, it is essential to provide a balun to convert the single-ended signal output from the antenna to a differential signal. The balun is difficult to fabricate in an integrated circuit by silicon processing, which in turn gives trouble in integrating the entire receiver circuitry into a single integrated circuit when using the conventional variable gain amplifier along with the receiver circuitry. If the balun is to be used with receiver circuitry, but built separately from the integrated circuit as a chip component, the receiver circuitry will need an increased footprint and thickness in mounting. In addition, if the balun is used with the receiver circuitry, the balun dissipates some of the reception power, degrading reception sensitivity and other quality factors. In addition, document US 2002/0113656 A1 discloses an amplifier including two or more amplification stages. The rear amplification stage amplifies an output signal of a front stage transistor that is comprised of two or more transistors in parallel whose base currents are controllable.

SLTMMARY OF THE INVENTION

The present invention has an objective to provide a variable amplifier which can be directly connected to an antenna, a filter coupled with it, or to another single-ended signal source with no intervening balun or like components, and to provide also a mobile wireless terminal containing receiver circuitry which requires reduced mounting footprint and thickness, but boasts excellent reception sensitivity and other characteristics.
According to the present invention, this object is accomplished by a variable amplifier according to claim 1, and by a mobile wireless terminal according to claim 13.
Advantageous further developments are subject of the accompanying dependent claims.
According to the invention, the variable amplifier is not differential, but in a simple common emitter configuration. Therefore, the input is single-ended. When connected to a single-ended signal source, such as an antenna or a filter connected to the antenna, the variable amplifier needs no balun or like single-ended/differential converter. The variable amplifier therefore can be directly coupled to a single-ended signal source. In addition, by suitably regulating the characteristics of the signal paths and suitably controlling the base currents of the transistors, the variable amplifier exhibits a desirable range of variable gain, linearity, noise, and other characteristics.

The base current control section preferably controls the base currents of the transistors so as to vary the overall gain of the variable amplifier. Thus, a variable gain amplifier is realized.

The paths preferably include first signal paths and a second signal path which amplifies a signal at a smaller signal amplifying gain and higher signal amplifying linearity than the first signal paths. When this is the event, the second signal path preferably has an attenuator attenuating a signal between the associated one of the transistors and the input terminal.

According to the arrangement, a variable amplifier with a simple structure is realized.

The variable amplifier of the present invention may further include a secondary transistor with its emitter or source substantially connected to the collectors of the transistors. The base or gate of the secondary transistor is grounded in terms of high frequency components and the collector or drain of the secondary transistor is substantially connected to a load.

According to the above arrangement, the transistors are substantially cascaded to the secondary transistor. The variable amplifier is thus capable of easing mirror effect and improves the range of variable gain and linearity.

Here, the "grounding in terms of high frequency components" refers to the connection to a voltage source of a sufficiently low impedance at operating frequency. Conventionally, to achieve normal operation with a common base circuit, including cascaded components, the base needs to be coupled to a constant voltage. It was therefore desirable to provide a voltage source (voltage generate circuit) generating the constant voltage for connection to the bases of the common base circuit. A simple method to generate a desired voltage is to divide a source voltage. This requires sufficiently low impedance, which can be achieved by, for example, passing five times as much current through the voltage divider resistors as through the base current of the common base circuit or coupling a capacitor to the base of the common base circuit for sufficiently low impedance at operating frequency.

The variable amplifier of the present invention may include multiple secondary transistors each having an emitter or a source connected to a different one of the collectors of the transistors.

The arrangement prevents signal leak from non-operating common emitter transistors, thereby achieving high signal isolation. This extends the range of variable gain and improves linearity.

The variable amplifier of the present invention may further include a voltage control section controlling base voltages or gate voltages of the secondary transistors.

According to the arrangement, the base voltages or gate voltages of the secondary transistors can be actively turned off in accordance with the operation status of the common emitter transistors. This further improves the characteristics.

The variable amplifier of the present invention may be adapted so that the voltage control section allows substantially zero base voltages or gate voltages for the secondary transistors when the base currents of the transistors are below or equal to a predetermined level.

The arrangement eases the development of distortion in the common emitter transistors when the base currents of the transistors are near zero (turned off).

The variable amplifier of the present invention may be adapted so that the transistors form respective unit amplifiers, and at least one of the unit amplifiers differs from other unit amplifiers in a characteristic.

The arrangement optimizes the characteristics of the unit amplifiers in accordance with the characteristics required with the individual unit amplifiers, thus greatly improving overall characteristics of the variable amplifier.

It is preferable if the transistors form respective unit amplifiers, the paths include first signal paths and a second signal path which amplifies a signal at a smaller gain than the first signal paths, and the unit amplifier on the second signal path has higher linearity than the unit amplifiers on the first signal paths. Higher linearity can be given to the unit amplifier on the second signal path than to the unit amplifiers on the first signal paths by, for example, the following techniques: (1) Negative feedback is given to the transistor forming the unit amplifier on the second signal path, whereas no negative feedback is given to the transistors forming the unit amplifiers on the first signal paths. (2) Current density is increased by designing the transistor forming the unit amplifier on the second signal path in smaller size than transistors forming the unit amplifiers on the first signal paths.

The variable amplifier of the present invention may be adapted so that the base current control section controls the base currents of the transistors so that a combined current consumption in the transistors varies in accordance with a change in a ratio of the base currents of the transistors.

The arrangement enables regulation of the current consumption in the transistors in accordance with the characteristics needed by the unit amplifiers formed by the transistors. This eliminates the overall current consumption in the variable amplifier.

A mobile wireless terminal of the present invention is characterized in that it includes an amplifier amplifying a received signal and the amplifier is the variable amplifier having one of the foregoing arrangements.

The arrangement enables direct coupling of the input of the variable amplifier to an antenna or a bandpass filter directly coupled to the antenna. A balun is thus no longer required which would be necessary in mobile wireless terminals built around a conventional, differential variable gain amplifier circuit. The elimination of the balun not only contributes to the overall circuit downsizing in the mobile wireless terminal, but also to reception power savings by eliminating the power dissipation in the balun. This realizes more compact, high performance (high sensitivity) mobile wireless terminals with an extended operation time.

Additional objects, advantages and novel features of the invention will be set forth in part in the description which follows, and in part will become apparent to those skilled in the art upon examination of the following or may be learned by practice of the invention.

BRIEF DESCRIPTION OF THE DRAWINGS

Figure 1 is a circuit diagram illustrating the arrangement of a variable amplifier in accordance with an embodiment of the present invention.

Figure 2 is a circuit diagram illustrating the arrangement of a base current control circuit in the variable amplifier.

Figure 3 is a graph depicting how the base currents of three transistors in the variable amplifier vary with a control voltage.

Figure 4 is a graph depicting how the overall gain and IIP3 of the variable amplifier vary with a control voltage.

Figure 5 is a circuit diagram illustrating a variation of the variable amplifier in accordance with the embodiment.

Figure 6 is a circuit diagram illustrating the arrangement of a variable amplifier in accordance with another embodiment of the present invention.

Figure 7 is a graph depicting a gain-frequency characteristic of the variable amplifier in Figure 1 and of the variable amplifier in Figure 6 for comparison.

Figure 8 is a circuit diagram illustrating the arrangement of a variable amplifier in accordance with a further embodiment of the present invention.

Figure 9 is a graph depicting a gain-control voltage and an IIP3-control voltage characteristic of the variable amplifier in Figure 6 and of the variable amplifier in Figure 8 for comparison.

Figure 10 is a circuit diagram illustrating the arrangement of a base voltage control circuit in a variable amplifier in accordance with still another embodiment of the present invention.

Figure 11 is a graph depicting a base current-control voltage characteristic of a transistor in a common emitter configuration and a base voltage-control voltage characteristic of a transistor in a common base configuration, both transistors making up the variable amplifier with the base voltage control circuit in Figure 10.

Figure 12 is a graph depicting a base current-control voltage characteristic of a transistor in a common emitter configuration and a base voltage-control voltage characteristic of a transistor in a common base configuration, both transistors making up a variable amplifier in accordance with yet another embodiment of the present invention.

Figure 13 is a graph depicting, for comparison, a gain-control voltage and an IIP3-control voltage characteristic of the variable amplifier with the base voltage control circuit in Figure 10 and of the variable amplifier having the characteristics shown in Figure 12.

Figure 14 is a circuit diagram illustrating the arrangement of a variable amplifier in accordance with a further embodiment of the present invention.

Figure 15 is a circuit diagram illustrating the arrangement of a base current control circuit controlling the base current of a transistor in a common emitter configuration in a variable amplifier in accordance with a further embodiment of the present invention.

Figure 16 is a block diagram illustrating the arrangement of a mobile wireless terminal containing a variable amplifier in accordance with the present invention.

DESCRIPTION OF THE EMBODIMENTS

EMBODIMENT 1

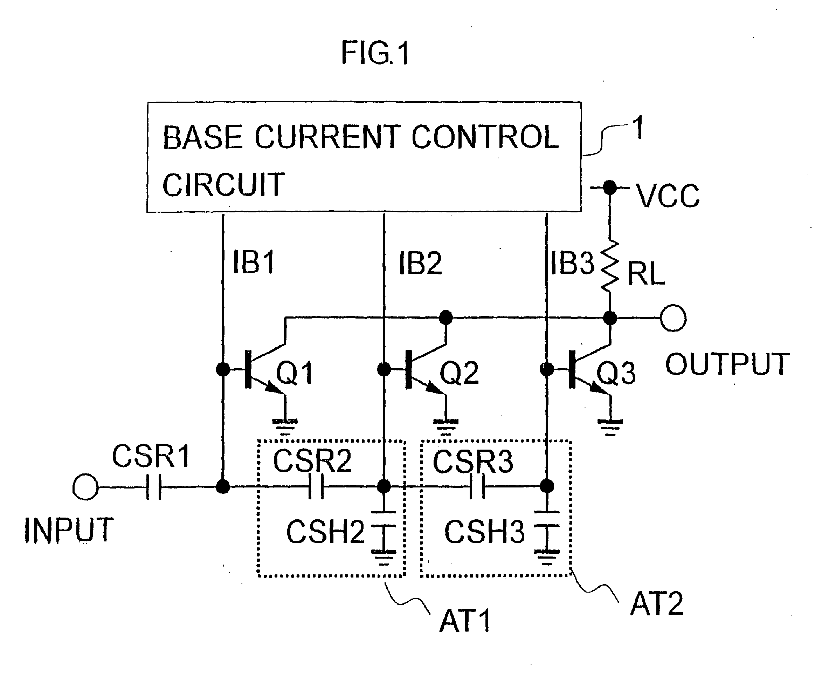

Referring to Figure 1 to Figure 4, the following will describe an embodiment of the present invention. A variable amplifier of the present embodiment is arranged to vary its overall gain and linearity by switching between a set of unit amplifiers connected in parallel between a signal input and a signal output. The switchable stage count (i.e., the number of switchable unit amplifiers) may be any number more than or equal to 2. The count is 3 in the Figure 1 example (detailed description will be given later).

In the variable amplifier of the present embodiment, at least one of the signal paths which extend from the signal input to the signal output via a set of transistors differs in gain and linearity from the others, so that the overall gain and linearity of the variable amplifier can vary with the switching between the unit amplifiers. In the Figure 1 example (will be detailed later), each signal path from the signal input to one of the transistors differs in attenuation from the others.

In the variable amplifier of the present embodiment, each unit amplifier contains only one transistor, i.e. one stage, which is an npn bipolar transistor. Further, all the transistors have the same characteristics: specifically, they are all SiGe bipolar transistors with an 20 _m × 0.5 _m emitter area.

Figure 1 is a circuit diagram illustrating the arrangement of a variable amplifier in accordance with an embodiment of the present invention (the base current control circuit is represented by a block). The variable amplifier of the present embodiment, as shown in Figure 1, contains three signal-amplifying transistors: a first transistor Q1, a second transistor Q2, and a third transistor Q3 (detailed later). The amplifier also contains a base current control circuit (base current control section or base current switching circuit) 1.

The transistors Q1 to Q3 are connected in parallel between an input terminal (signal input terminal) INPUT where a signal having a DC component is applied and an output terminal (signal output terminal) OUTPUT where the signal is output after being amplified. The transistors Q1 to Q3 are grounded at their emitters. The collectors of the transistors Q1 to Q3 are connected to the output terminal OUTPUT and also to the same end of a common load resistor RL. The other end of the resistor RL is connected to a power supply line VCC through which is supplied a source voltage.

The input terminal INPUT is connected to the base of the first transistor Q1 via a capacitor CSR 1 which removes the DC component from the input signal. The input terminal INPUT is connected also to the base of the second transistor Q2 via the capacitor CSR1 and an attenuator AT1 which attenuates an input signal. The attenuator AT1 contains a capacitor CSR2 and capacitor CSH2. The capacitor CSR2 is connected in series with the base of the first transistor 1 and in series with the capacitor CSR1. The capacitor CSH2 shunts a signal path successive to the capacitor CSR2, i.e. a signal path connecting the capacitor CSR2 to the base of the second transistor Q2, to ground. Similarly, the input terminal INPUT is connected to the base of the third transistor Q3 via the capacitor CSR1, the attenuator AT1, and another attenuator AT2 which attenuates the input signal. The attenuator AT2 contains a capacitor CSR3 and a capacitor CSH3. The capacitor CSR3 is connected in series with the base of the second transistor Q2 and in series with the capacitor CSR2. The capacitor CSH3 shunts a signal path successive to the capacitor CSR3, i.e. a signal path connecting the capacitor CSR3 to the base of the third transistor Q3, to ground.

Now, we consider the characteristics of the three signal paths ("Q1 path," "Q2 path," and "Q3 path") extending from the input terminal INPUT to the output terminal OUTPUT via the transistors Q1 to Q3 respectively. Assume here that the currents through the bases of the transistors Q1 to Q3 are equal. The transistor Q1 receives a signal fed to the input terminal INPUT directly, i.e. without no intervening attenuator. The Q1 path is therefore has the largest gain of the three signal paths. In contrast, the transistor Q2 receives a signal fed to the input terminal INPUT via the attenuator AT1. The Q2 path therefore has a smaller gain and higher linearity than the Q1 path. The transistor Q3 receives a signal fed to the input terminal INPUT via the attenuators AT1, AT2. The Q3 path therefore has a smaller gain and higher linearity than the Q2 path.

Further, the bases of the transistors Q1 to Q3 are connected to the terminals IB1 to IB3 of the base current control circuit 1 so that the base current control circuit 1 can control the individual current flows through the bases of the transistors Q1 to Q3 (base currents).

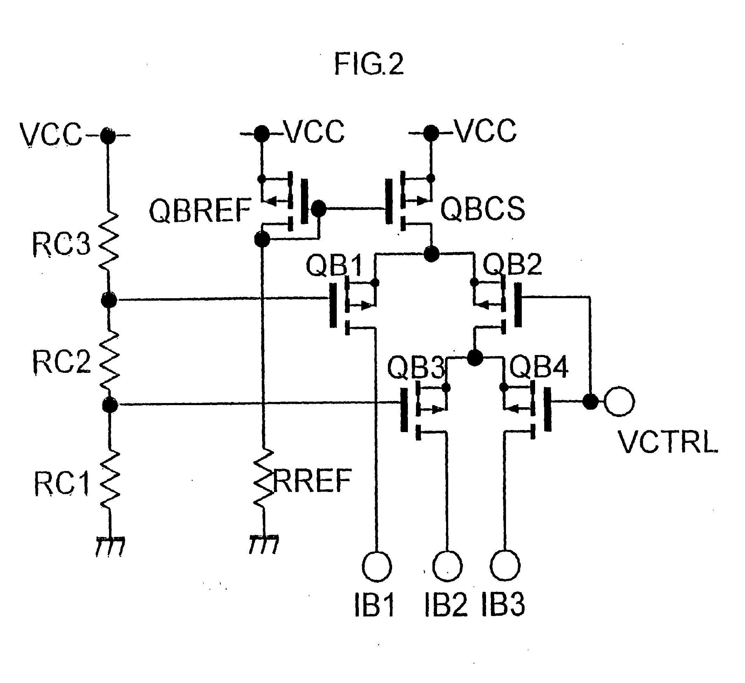

The base current control circuit 1, as shown in Figure 2, contains: resistors RC1, RC2, RC3 producing reference voltages; a resistor RREF setting a base current sum; field effect transistors QBREF, QBCS constituting a current mirror circuit which sets a current sum; field effect transistors QB1, QB2 constituting a first differential pair; and field effect transistors QB3, QB4 constituting a second differential pair. The transistors QBREF, QBCS, QB1, QB2, QB3, QB4 are p-channel MOS (metal oxide semiconductor) transistors.

The transistors QBREF, QBCS constitute a current mirror circuit: the gate and drain of the transistor QBREF and the gate of the transistor QBCS are all connected together. The transistor QBREF is coupled to the power supply line VCC at its source and to an end of the resistor RREF at its drain and gate. The other end of the resistor RREF is grounded. The transistor QBCS is coupled to the power supply line VCC at its source and to the sources of the transistors QB1, QB2 at its drain. The current mirror circuit sets the sum of the current flows through the bases of the transistors Q1 to Q3 (hereinafter, the "base current sum") so that the sources of the transistors QB1, QB2 conduct a combined current flow which is equal to the current sum setting. The current setting resistor RREF dictates the current flow through the gate and drain of the transistor QBREF. Based on this current flow, the current mirror circuit determines the current flow through the sources of the transistors QB1, QB2 (base current sum). If the transistor QBREF and the transistor QBCS, combined to form a current mirror circuit, are of the same size, the combined current flow through the drains of the transistors QB1, QB2 (base current sum) becomes equal to the current determined by the current setting resistor RREF which is invariable over time.

The resistors RC1, RC2, RC3 are connected in series between the power supply line VCC through which is supplied a source voltage and ground. They divide the source voltage to produce reference voltages VR1, VR2 (VR1 < VR2).

The transistors QB1, QB2 are coupled to each other at their sources, thus forming the first differential pair. The gate of the transistor QB1 is fed with the reference voltage VR2. Meanwhile, the gate of the transistor QB2 is fed with an external variable control voltage VCTRL via a control voltage terminal VCTRL. The drain of the transistor QB1 is coupled to the base of the transistor Q1 via the terminal IB1. The drain of the transistor QB2 is coupled to the sources of the transistors QB3, QB4. The first differential pair determines a ratio of the current flow through the base of the transistor Q1 and the current flow through the sources of the transistors QB3, QB4 in accordance with the magnitude relationship between the control voltage VCTRL and the reference voltage VR2.

The transistors QB3, QB4 are coupled to each other at their sources, thus forming the second differential pair. The gate of the transistor QB3 is fed with the reference voltage VR1. Meanwhile, the gate of the transistor QB4 is fed with an external variable control voltage VCTRL via a control voltage terminal VCTRL. The drain of the transistor QB3 is coupled to the base of the transistor Q2 via the terminal IB2. The drain of the transistor QB4 is coupled to the base of the transistor Q3 via the terminal IB3. The second differential pair determines a ratio of the current flow through the base of the transistor Q2 and the current flow through the base of the transistor Q3 in accordance with the magnitude relationship between the control voltage VCTRL and the reference voltage VR1.

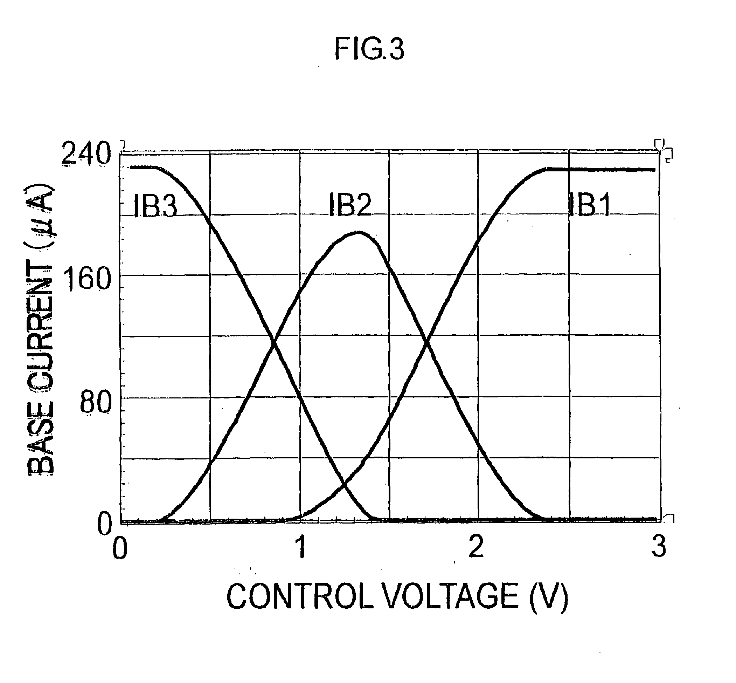

Thus, in the base current control circuit 1, the base current sum flowing through the sources of the transistors QB1, QB2 at a value determined by the transistors QBREF, QBCS are divided among the terminals IB1 to IB3 by means of the transistors QB1, QB2, QB3, QB4 in accordance with the control voltage VCTRL. As a result, the ratio of current values IB1 to IB3 at the terminals IB1 to IB3 (that is, at the bases of the transistors Q1 to Q3) changes continuously in accordance with the control voltage VCTRL. This is shown in Figure 3 illustrating the switching characteristics of the current flows through the bases of the transistors Q1 to Q3 (base currents), that is, changes in the base currents with the control voltage.

In the illustrated case, the proportion of the current value IB1 to the base current sum stays at 0% when the control voltage VCTRL is up to about 0.9 V and continuously increases from 0% to 100% when the control voltage VCTRL rises from the about 0.9 V to about 2.35 V. The proportion is 100% when the control voltage VCTRL is in excess of about 2.35 V. The proportion of the current value IB2 to the base current sum stays at 0% when the control voltage VCTRL is up to about 0.2 V and continuously increases from 0% to about 80% when the control voltage VCTRL rises from about 0.2 V to about 1.35 V. The proportion then continuously decreases from about 80% to 0% when the control voltage VCTRL rises from about 1.35 V to about 2.35 V and stays at 0% when the control voltage VCTRL is in excess of about 2.35 V. The proportion of the current value IB3 to base current sum is 100% when the control voltage VCTRL less than about 0.2 V and continuously decreases from 100% to 0% when the control voltage VCTRL rises from about 0.2 V to about 1.45 V. The proportion stays at 0% when the control voltage VCTRL is in excess of about 1.45 V. Taken together, the ratio of the current values IB1 to IB3 at the bases of the transistors Q1 to Q3 changes continuously with the control voltage VCTRL provided that the control voltage VCTRL is from about 0.2 V to about 2.35 V.

Next will be described the operation of the variable amplifier in response to changes of the control voltage VCTRL. When the control voltage VCTRL is sufficiently high (about 2.4 V or higher) relative to the reference voltages VR1 (= 0.85 V) and VR2 (= 1.7 V), the transistors QB2, QB4 in the base current control circuit 1 turn off. This causes the base current sum, as determined by the current mirror circuit (transistors QBREF, QBCS) used for current sum setting purposes, to entirely flow to the base of the transistor Q1 in the amplifier via the transistor QB1. The other transistors Q2, Q3 turn off. In this state, the transistor Q1 receives the signal fed to the input terminal INPUT with no intervening attenuators, producing the greatest gain. In addition, IIP3 (Input third order Intercept Point or third order intermodulation expressed in dB_V or dBc), which is an indicator of the variable amplifier's overall linearity is the linearity of the transistor Q1 itself.

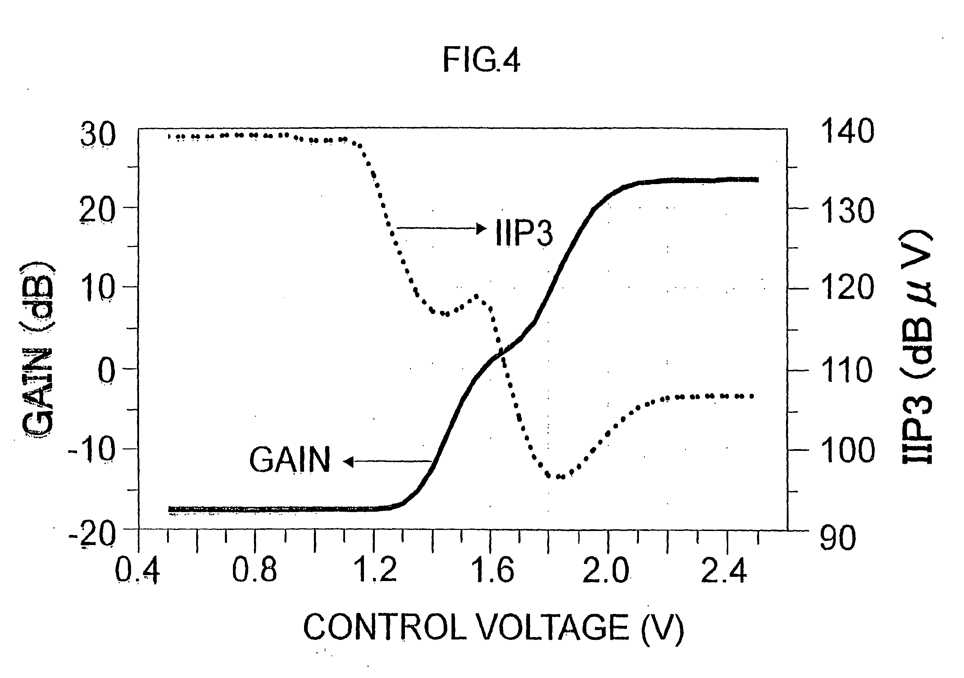

As the control voltage VCTRL falls, the current flow through the base of the transistor Q1 is partially diverted to the base of the transistor Q2. Specifically, with a falling control voltage VCTRL, the base current of the transistor Q1 gradually decreases, and the base current of the transistor Q2 gradually increases. In the transistor Q1, the collector current thus decreases, gradually reducing the gain. In contrast, in the transistor Q2, the collector current increases, gradually raising the gain. Since the Q2 path has a lower gain than the Q1 path at the same base current as mentioned earlier, the overall gain of the variable amplifier drops (see Figure 4). Moreover, since the Q2 path has high linearity than the Q1 path at the same base current as mentioned earlier, the overall linearity of the variable amplifier rises (see Figure 4).

At a sufficiently low control voltage VCTRL, the collector current of the transistor Q2 increases to a level at which the gain of the transistor Q2 is so large that the transistor Q1 in practice turns off. The variable amplifier exhibits a relatively small overall gain due to the presence of the attenuator AT1 on the input path of the transistor Q2. IIP3 of the variable amplifier as a whole is equivalent to the property of the transistor Q2 plus the attenuation ratio in decibels (dB).

As the control voltage VCTRL drops further to or below about 0.2 V, the transistors QB1, QB3 turn off. Thus, all of the base current sum as determined by the resistor RREF and the transistors QBREF, QBCS in the base current control circuit 1 flows to the base of the transistor Q3 via the transistor QB1, turning off both the other transistors Q1, Q2. In this state, the signal fed to the input terminal INPUT is supplied to the transistor Q3 via the attenuators AT1, AT2. The variable amplifier exhibits the lowest overall gain. Conversely, IIP3 of the variable amplifier as a whole is highest.

The gain- and IIP3-control voltage VCTRL characteristics are shown in Figure 4.

As detailed in the foregoing, the variable amplifier of the present embodiment offers variable gain over a wide range and achieves high linearity at a large-signal, low-gain condition. The variable amplifier of the present embodiment contains amplifier circuitry of a common emitter configuration, not a differential circuit configuration which is often used in silicon RFICs (radio frequency integrated circuits). Therefore, the variable amplifier of the present embodiment receives a single-ended signal input (unbalanced input), not a differential signal input. This enables the variable amplifier of the present embodiment to be directly connected to an antenna, filter, and other single-ended signal sources.

Further, power consumption occurs practically only in the amplifier section, constituted by a single transistor, and its associated load resistor. The variable amplifier of the present embodiment therefore operates at low source voltages: for example, as low as about 1 V. In contrast, the differential circuit needs a current source, an amplifier section, and a load resistor. The amplifier section needs be made up of two stages of transistors, and the source voltage cannot be reduced much.

The gain-control voltage characteristic of the variable amplifier shown in Figure 1 (see Figure 4) contains small curves and is not much linear. The gain-control voltage characteristic however becomes more linear with a greater switchable stage count (number of switchable unit amplifiers), at a cost of increased circuit dimensions. The switchable stage count should hence be determined so as to strike a good balance between the circuit dimensions and the linearity of the gain-control voltage characteristic.

In addition, the present embodiment, so far having assumed an npn transistor, may be applied to a pnp transistor to provide a similar variable amplifier.

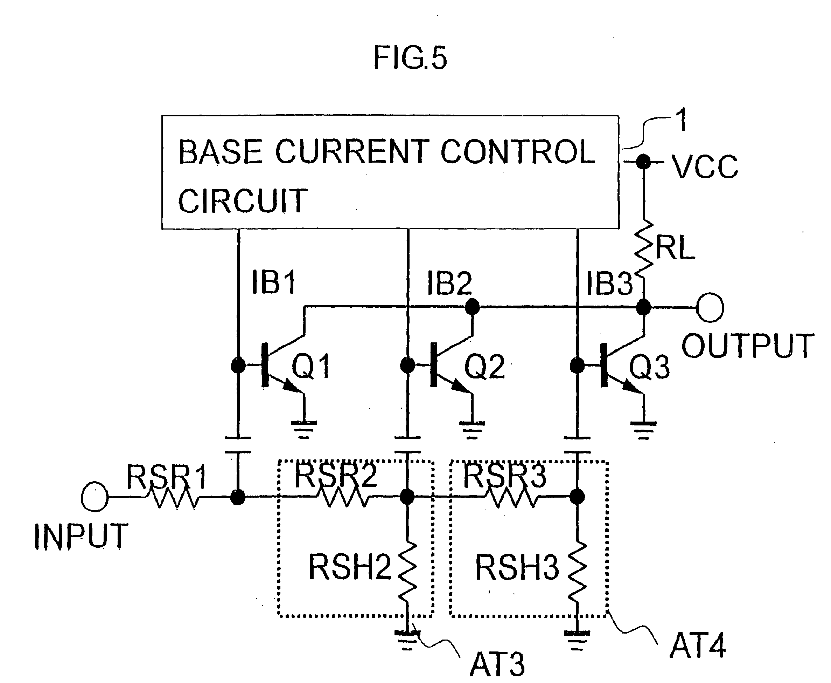

Further, the present embodiment has so far assumed the attenuators AT1, AT2, inserted between the input terminal INPUT and the transistors Q2, Q3, being built around a capacitor. The capacitor-based attenuator structure is by no means limited in any particular manner. Other structures are also available. In addition, as shown in Figure 5, the capacitor-based attenuators AT1, AT2 may both be replaced with resistor-based attenuators AT3, AT4. In such cases, however, the bases of the transistors Q1 to Q3 need be DC-isolated from the attenuators AT3, AT4 for operation. This is done by inserting capacitors CDC1, CDC2, CDC3 respectively between the transistors Q1 to Q3 in a common emitter configuration and the attenuators AT3, AT4. Moreover, in the variable amplifier shown in Figure 5, a resistor RSR1 is provided between the bases of the transistors Q1 to Q3 and the input terminal INPUT.

The attenuator AT3 contains a resistor RSR2 and a resistor RSH2. The resistor RSR2 is connected in series with the base of the first transistor Q1 and in series with the resistor RSR1. The resistor RSH2 shunts a signal path successive to the resistor RSR2, i.e. a signal path connecting the resistor RSR2 to the base of the second transistor Q2, to ground. The attenuator AT4 contains a resistor RSR3 and a resistor RSH3. The resistor RSR3 is connected in series with the base of the second transistor Q2 and in series with the resistor RSR2. The resistor RSH3 shunts a signal path successive to the resistor RSR3, i.e. a signal path connecting the resistor RSR3 to the base of the third transistor Q3, to ground.

The resistor-based attenuators AT3, AT4 have following advantages over the capacitor-based attenuators: (1) They make the variable amplifier smaller and especially, when integrated into a chip, occupy a smaller chip area. (2) They permit less signal leak in the variable amplifier and especially, when the circuitry is mounted on a single board, less signal leak through the board. (3) They are more readily matched. The resistor-based attenuator structure is again by no means limited in any particular manner. Also, in the structure in Figure 5, the resistor RSR1 is not essential.

In addition, in the present embodiment, the base current control circuit is the analog circuit arranged as shown in Figure 2. However, this base current control circuit for use with base current is not limited in any particular manner provided that it is capable of continuously changing the ratio of current values IB1 to IB3 at the bases of the transistors Q1 to Q3 over a predetermined range in accordance with the control voltage VCTRL. For example, the base current control circuit may be structured to digitally control the base currents of the transistors Q1 to Q3 by using a D/A (digital-analog) converter. Base current control circuits of different structures may also be used when the base currents of the transistors Q1 to Q3 is controlled by means of analog circuitry.

Further, the base current control circuit of the present embodiment is designed to produce a substantially constant base current sum. However, the base current sum is not necessarily constant. A large current may be supplied to an amplifier section where linearity matters, and a small current to an amplifier section where linearity does not matter much. Specifically, the base current sum may be greater when producing a maximum base current for the transistor Q3 where linearity matters in comparison with the other transistors Q1, Q2 than when producing a maximum base current for the transistor Q2. Alternatively, the base current sum may be smaller when producing a maximum base current for the transistor Q1 where linearity does not matter much than when producing a maximum base current for the transistor Q2. Further, the base currents of the transistors Q2, Q3 may be reduced while providing such a negative feedback to the transistors Q2, Q3 that results in sufficient linearity. The transistor Q1 needs some current because it needs to offer all the high linearity, low noise, and large gain performance. The transistors Q2, Q3 meanwhile are not required to offer that level of high gain, low noise performance, allowing the use of a negative feedback to reduce power consumption. Note an advantage of a constant base current sum for the transistors Q1 to Q3: the DC voltage output becomes substantially constant.

The variable amplifier of the present embodiment has so far assumed that each signal path extending from the signal input terminal to the signal output terminal via a set of transistors has different characteristics from the others. However, some of the signal paths may share the same characteristics provided that at least one of them has different characteristics from the others.

The variable amplifier of the present embodiment has so far assumed that its gain and linearity are changeable through the control of the current flow through the bases of the transistors. Alternatively, any other characteristics may be changeable through the control of the current flow through the bases of the transistors.

As in the foregoing, the variable amplifier of the present embodiment contains a set of bipolar transistors having their emitters substantially grounded and collectors connected to substantially identical loads. The amplifier changes its overall characteristics through changes of the base currents through the transistors. This structure employs a simple common emitter configuration, not a differential circuit. The input is single ended, and no single-ended or differential converter, such as a balun, is needed. Also, the amplifier offers desirable characteristics, including a range of variable gain, linearity, and noise performance.

As in the foregoing, the variable amplifier of the present embodiment is an amplifier circuit with a set of emitters being grounded. The variable amplifier achieves a wide range of gains and linearity by changing its overall characteristics through continuous (analog) switching by means of an analog signal between the base currents of the bipolar transistors used in the amplification.

There exist now many single-ended variable gain amplifiers. Many of them provides a variable gain. But, linearity is not variable, or if at all becomes poorer at lower gains. The single-ended variable gain amplifier of the present invention makes a good contrast to this: as mentioned earlier, the linearity progressively improves with a fall in gain. This feature is found in differential-input variable gain amplifiers, predating the current invention, which were detailed in the "BACKGROUND OF THE INVENTION" above, but not in single-end variable gain amplifiers predating the current invention. Hence, it is concluded that the present invention has succeeded in providing a single-ended variable gain amplifier with low noise at large gains and high linearity at low gains.

EMBODIMENT 2

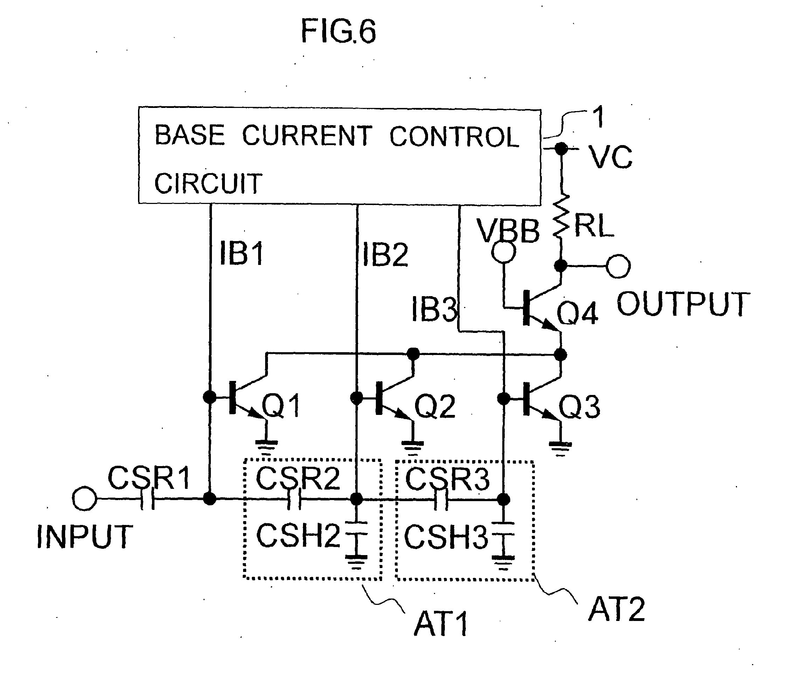

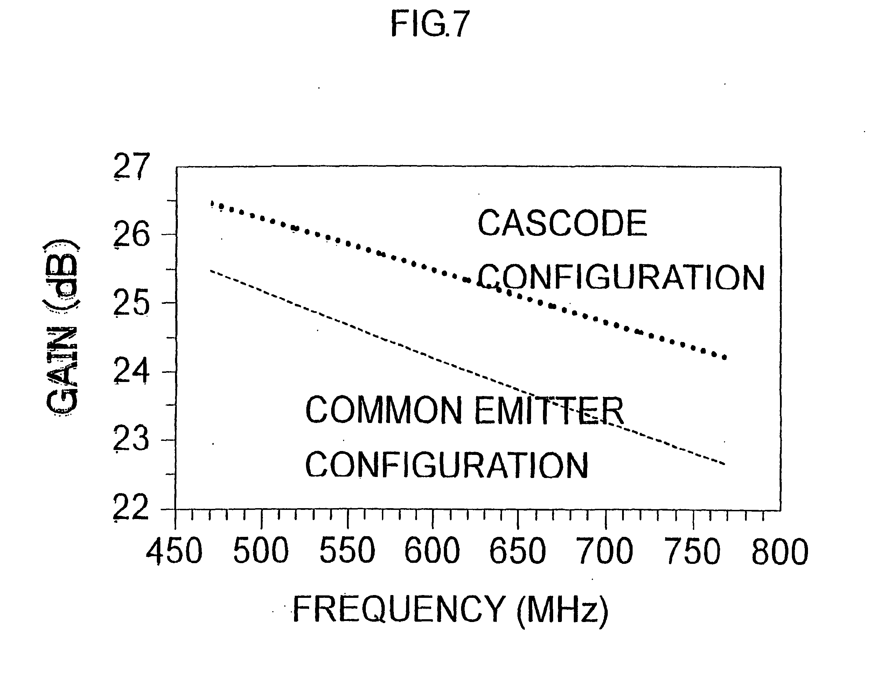

Referring to Figures 6, 7, the following will describe another embodiment of the present invention. Here, for convenience, members of the present embodiment that have the same arrangement and function as members of embodiment 1, and that are mentioned in that embodiment are indicated by the same reference numerals and description thereof is omitted.

In the variable amplifier of embodiment 1, the base/collector capacitances of the transistors Q1 to Q3 are increased by mirror effect due to the simple common emitter configuration. The variable amplifier of embodiment 1 does not therefore exhibit very good characteristics at high frequencies.

Accordingly, the variable amplifier of the present embodiment employs a cascade connection to improve characteristics at high frequencies. Figure 6 illustrates the arrangement of a variable amplifier of the present embodiment.

In the variable amplifier of embodiment 1, the collectors of the common emitter transistors Q1 to Q3 were connected to a load resistor RL. In the variable amplifier of the present embodiment, the common emitter bipolar transistors Q1 to Q3 are cascaded to a secondary transistor Q4. The emitter of the transistor Q4 is coupled to the collectors of the common emitter transistors Q1 to Q3. The collector of the transistor Q4 is coupled to the load resistor RL. The transistor Q4 is grounded in terms of high frequency components as the transistor Q4 is fed at its base with a fixed bias voltage VBB (= 2.0 V) from a terminal VBB. Hereinafter, a transistor which is grounded in terms of high frequency components like this one will be referred to as a "common base transistor." This is the only major difference between the arrangement of the variable amplifier of embodiment 1 and that of the variable amplifier of the present embodiment.

Similarly to embodiment 1, the variable amplifier of the present embodiment contains npn bipolar transistors as the common emitter transistors Q1 to Q3. The common base transistor Q4 is also an npn bipolar transistor. Similarly to embodiment 1, the base currents of the common emitter transistors Q1 to Q3 are under the control of the base current control circuit 1 shown in the circuit diagram of Figure 2. The variable amplifier of the present embodiment produces similar effects to embodiment 1.

Figure 7 shows simulated gain-frequency characteristics, one for the variable amplifier of embodiment 1 and the other for the variable amplifier of the present embodiment. The variable amplifier of the present embodiment shows a gain of great absolute values and a somewhat improved frequency characteristic when compared with the variable amplifier of embodiment 1. This is presumably due to the cascade connection easing mirror effect.

The variable amplifier shown in Figure 6 contains the common base bipolar transistor Q4 as the secondary transistor cascaded to the collectors of the common emitter transistors Q1 to Q3. the secondary transistor may be a field effect transistor (FET), such as a MOS transistor, with its gate being grounded. When this is the case, the field effect transistor should be coupled through its source to the collectors of the transistors Q1 to Q3 and through its drain to the load resistor RL.

As detailed in the foregoing, the variable amplifier of the present embodiment includes a first group of transistors and a second transistor. The first group of bipolar transistors are substantially grounded at their emitters and substantially connected through their collectors to the emitter or source of the second transistor. The base or gate of the second transistor is grounded in terms of high frequency components. That is, the second transistor has a common base configuration or a common gate configuration. The collector or drain of the second transistor is substantially connected to a load. The overall characteristics of the amplifier are varied by regulating the base currents of the first group of transistors. The circuit construction includes a substantial cascade connection and eases mirror effect, improving the range of the variable gain and linearity over embodiment 1.

EMBODIMENT 3

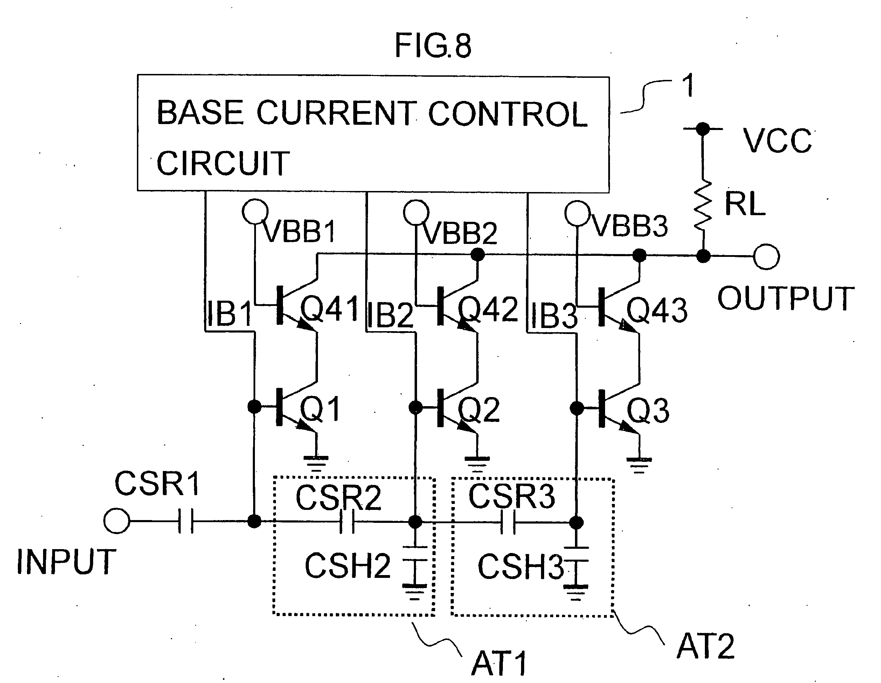

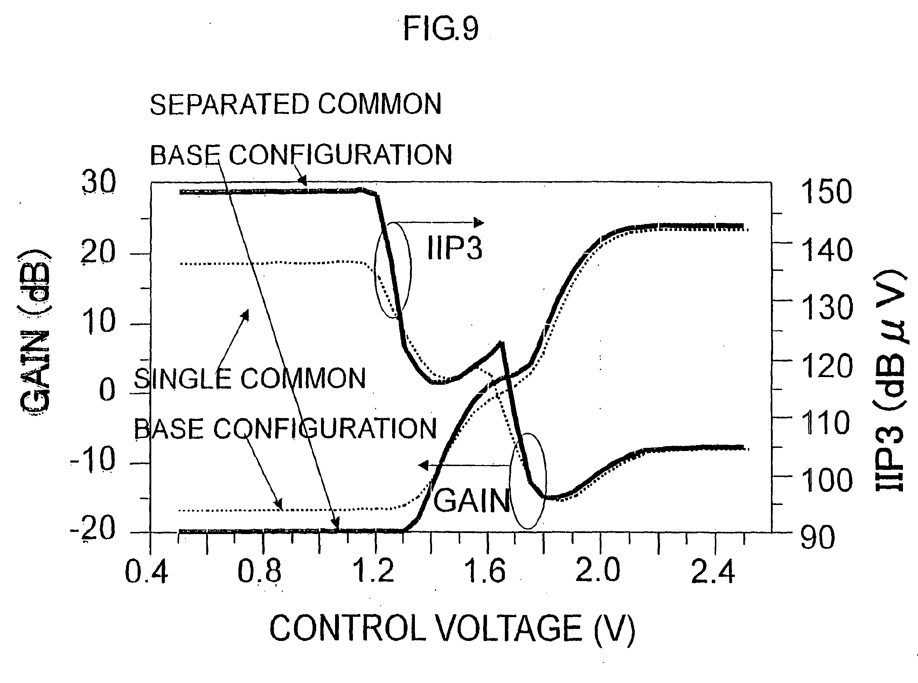

Referring to Figures 8, 9, the following will describe another embodiment of the present invention. Here, for convenience, members of the present embodiment that have the same arrangement and function as members of embodiment 1 or 2, and that are mentioned in that embodiment are indicated by the same reference numerals and description thereof is omitted.

Figure 8 is a circuit diagram of a variable amplifier of the present embodiment. The variable amplifier of embodiment 2 contained the single transistor Q4 as the common base transistor cascaded to the common emitter transistors. The transistor Q4 was common to the common emitter transistors Q1 to Q3. In contrast, in the variable amplifier of the present embodiment, the common emitter transistors Q1 to Q3 are cascaded to respective transistors Q41 to Q43 in a common base configuration. The transistors Q41 to Q43 are coupled through their emitters respectively to the collectors of the common emitter transistors Q1 to Q3 and through their collectors respectively to the common load resistor RL. This is the only major difference between the arrangement of the variable amplifier of embodiment 2 and that of the variable amplifier of the present embodiment. Similarly to embodiments 1, 2, all the transistors in the variable amplifier of the present embodiment are npn bipolar transistors. The collector of the transistor Q4 is connected to the load resistor RL. The transistors Q41 to Q43 are fed at their bases with fixed bias voltages VBB1 to VBB3 (= 2.0 V) from terminals VBB1, VBB2, VBB3 and also grounded in terms of high frequency components.

In the variable amplifier of embodiment 2, signal leak occurred through the base/collector capacitance of the common emitter transistors Q1 to Q3 even when the common emitter transistors Q1 to Q3 were off. The variable amplifier of the present embodiment makes a good contrast to this: the turning off of the common emitter transistors Q1 to Q3 stops the current flows through the collectors of the common base transistors Q41 to Q43, thereby turning off the common base transistors Q41 to Q43, due to the provision of the common base transistors Q41 to Q43 in association with the respective common emitter transistors Q1 to Q3. Therefore, in the common base transistors Q41 to Q43, signal leak may occur through the collector/emitter capacitance which is far smaller than the base/collector capacitance. The common base transistors Q41 to Q43 thus exhibit high signal isolation.

Figure 9 shows simulated gain- and IIP3-control voltage characteristics, one for the variable amplifier of embodiment 2 containing a common base transistor which is common to the transistors Q1 to Q3 (shared common base configuration) and the other for the variable amplifier of the present embodiment containing individual common base transistors for the transistors 1 to Q3 (separate common base configuration). It would be understood that the variable amplifier of the present embodiment exhibits improved isolation and improved IIP3 at low gains over the variable amplifier of embodiment 2 containing a shared common base transistor. The improvement of IIP3 is remarkable.

In the present embodiment, the common emitter transistors Q1 to Q3 have been provided with the individual additional common base transistors Q41 to Q43. However, not all the common emitter transistors Q1 to Q3 need an individual common base transistor. The common emitter transistors may be divided into groups with each group having its own common base transistor. For example, in the variable amplifier in Figure 8, the transistors Q2, Q3 may be provided with a common base transistor.

The variable amplifier of the present embodiment contains the common base bipolar transistors Q41 to Q43 as the transistors (secondary transistors) cascaded to the collectors of the common emitter transistors Q1 to Q3. Similarly to embodiment 2, the secondary transistors may be replaced with field effect transistors, such as MOS transistors, with their gate being grounded. When this is the case, the field effect transistors should be coupled through their sources to the collectors of the transistors Q1 to Q3 and through their drains to the load resistor RL.

As detailed in the foregoing, the variable amplifier of the present embodiment is a variation of the variable amplifier of embodiment 2 which included a first group of transistors and a second transistor: the second transistor is replaced with a set of transistors. The variable amplifier of the present embodiment differs from the variable amplifier of embodiment 2 in that there are provided a set of common base or common gate transistors, in place of a single transistor, in the cascade circuitry. The structure prevents signal leak through a non-operating common emitter transistor, achieving high isolation. This in turn extends the range of variable gain and improves linearity.

EMBODIMENT 4

Referring to Figures 8, 10, 11, the following will describe another embodiment of the present invention. Here, for convenience, members of the present embodiment that have the same arrangement and function as members of any one of embodiments 1 to 3, and that are mentioned in that embodiment are indicated by the same reference numerals and description thereof is omitted.

In the variable amplifiers of embodiments 2, 3, the biases to the common emitter transistors Q1, Q2 were controlled, whereas the biases to the common base transistors (Q4, Q41 to Q43) were fixed. In variable amplifiers of such an arrangement, the common base transistors (Q4, Q41 to Q43) only passively turn off when the current flow stops, and may turn on temporarily with a high level input signal. This insufficient isolation can be an obstacle in extending the range of the variable gain of the variable amplifiers in embodiments 2, 3. Also, the common base transistors (Q4, Q41 to Q43) are in operation (a small base current flows) even when they are off, which can cause distortion and degrade linearity.

To address this problem, the variable amplifier of the present embodiment differs from the Figure 8 circuit in that when any of the common emitter transistors Q1 to Q3 is/are off, the base voltage(s) of the off common base transistors Q41, Q42, Q43 is/are controlled so as to force the base voltage(s) of the associated common base transistors Q41, Q42, Q43 to substantially 0 V. Thus, the common base transistors Q41, Q42, Q43 are actively turned off, further improving isolation.

The variable amplifier of the present embodiment contains a base voltage control circuit controlling the base voltages VBB1 to VBB3 of the common base transistors Q41, Q42, Q43. The base voltage control circuit is coupled to the terminals VBB1, VBB2, VBB3 of the cascaded variable amplifier in Figure 8.

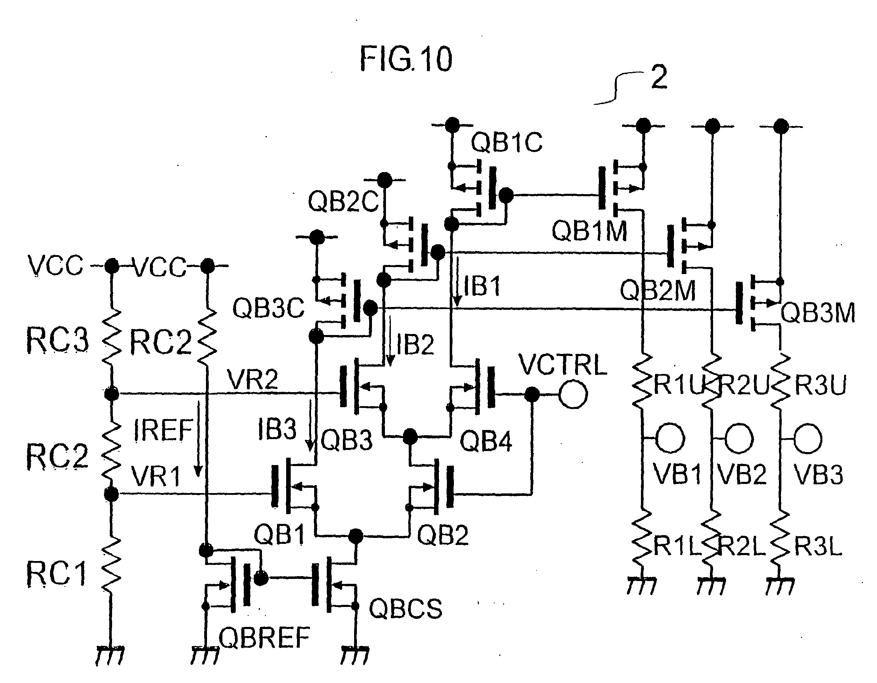

Figure 10 shows the arrangement of the base voltage control circuit (voltage control section) connected to the Figure 8 circuit.

Referring to Figure 10, the base voltage control circuit 2 differs from the base current control circuit 1 in Figure 2 as follows: The MOS transistor in the current switching section is an n-type field effect transistor (n-channel MOS transistor). A current mirror circuit is provided which contains a p-type field effect transistor (p-channel MOS transistor). The base current control circuit 1 in Figure 2 outputs current directly from the current switching section. In contrast, in the base voltage control circuit 2 in Figure 10, the current switching section controls the incoming current flow, and the current mirror circuit changes the direction in which the current flows. This operation raises the maximum tolerable output voltage. A mirror circuit made up of a transistor QB3C and a transistor QB3M is coupled to the drain of the transistor QB1. Another mirror circuit made up of a transistor QB2C and a transistor QB2M is coupled to the drain of the transistor QB3. Another mirror circuit made up of a transistor QB1C and a transistor QB1M is coupled to the drain of the transistor QB4. A pair of resistors R1U, R1L is coupled to the mirror circuit containing QB1M. Another pair of resistors R2U, R2L is coupled to the mirror circuit containing QB2M. Another pair of resistors R3U, R3L is coupled to the mirror circuit containing QB3M. The resistors pairs are provided to convert current from the mirror circuit to voltage. The transistors QB1C, QB1M, QB2C, QB2M, QB3C, QB3M are all p-type field effect transistors (p-channel MOS transistors).

In the base voltage control circuit 2, the currents IB1 to IB3 are converted to outgoing currents by the respective mirror circuits each made up of the transistor QBXC (X = 1, 2, 3) and the transistor QBXM (X = 1, 2, 3). These currents are converted to voltages by the resistors each made up of the resistor RXU (X = 1, 2, 3) and the resistor RXL (X = 1, 2, 3), so as to generate the base voltages VBB1 to VBB3 which are to be fed to the transistors Q41 to Q43.

As detailed in the foregoing, the base voltage control circuit 2 generates the base currents IB1 to IB3 in accordance with the control voltage VCTRL and then generates the base voltages VBB1, VBB2, VBB3 from the base currents IB1 to IB for output through the terminals VB1, VB2, VB3.

The currents IB1 to IB3 flowing respectively to the transistors QB4, QB3, QB1 shown in Figure 10 exhibit control voltage dependence as shown in Figure 3, similarly to the base current control circuit 1 shown in Figure 2.

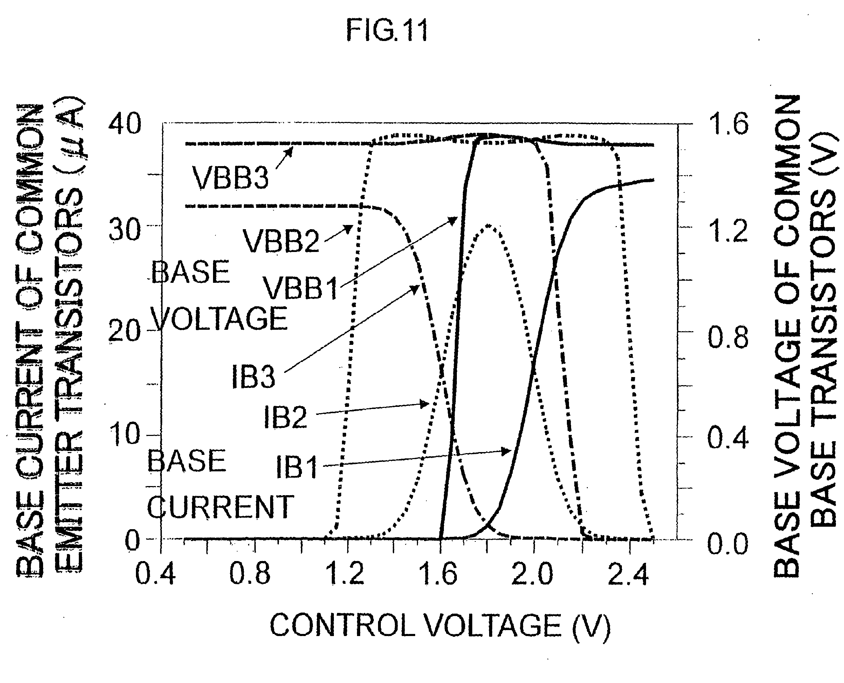

Supposing that the two transistors (transistor QBXC (X = 1, 2, 3) and transistor QBXM (X = 1, 2, 3)) making up a mirror circuit has the same gate width, the control voltage dependence of the base voltages shown in Figure 11 is obtained by determining the resistances of the resistors R1U, R1L, R2U, R2L, R3U, R3L and the currents IREF through the resistors so as to satisfy the relationship:

$$(RXU + RXL) \times IREF \gg Source\ Voltage.$$

In Figure 11, the base current of a common emitter transistor (Q1 to Q3) and the base voltage of its cascaded common base transistor (Q41 to Q43) are indicated by the same kind of line (solid, dashed, and dash-dot). Desirably, the base voltages VBB1 to VBB3 of the common base transistors Q41 to Q43 hardly vary when the common emitter transistors (Q1 to Q3) are in operation. It is therefore preferable if the currents through the resistors R1U, R1L, R2U, R2L, R3U, R3L are sufficiently large compared to necessary base currents.

Examining the switching characteristics reveals that when the base voltages VBB1 to VBB3 of the common base transistors Q41 to Q43 and the base currents IB1 to IB3 of the common emitter transistors Q1 to Q3 are falling, the base voltages VBB1 to VBB3 of the common base transistors Q41 to Q43 go off (falls almost to 0 V) after the base currents IB1 to IB3 of the common emitter transistors Q1 to Q3 drop to sufficiently low levels. When the common emitter transistors Q1 to Q3 are not in operation, the base voltages VBB1 to VBB3 of the common base transistors Q41 to Q43 are brought down to almost 0 V. This further improves the isolation, gain easing, and IIP3.

Similarly to base current control circuit, the circuit controlling the base voltages of the common base transistors Q41 to Q43 is not limited to the analog circuit shown in Figure 10 (base voltage control circuit 2). Various alternatives are available, including analog circuits of other structures. Another alternative is a circuit which digitally generates a control signal under computer control and then generates the base voltages of the common base transistors Q41 to Q43 from the control signal using a D/A converter so as to control the unit amplifiers.

As detailed in the foregoing, the variable amplifier of the present embodiment differs from the variable amplifier of embodiment 3 in that the base currents of the first group of transistors are varied and either the base or gate voltages of the multiple second transistors are varied. Further, the variable amplifier of the present embodiment is arranged so that the multiple common base or gate common transistors are actively turned off in accordance with the operation status of the common emitter transistors. The arrangement further improves the characteristics.

EMBODIMENT 5

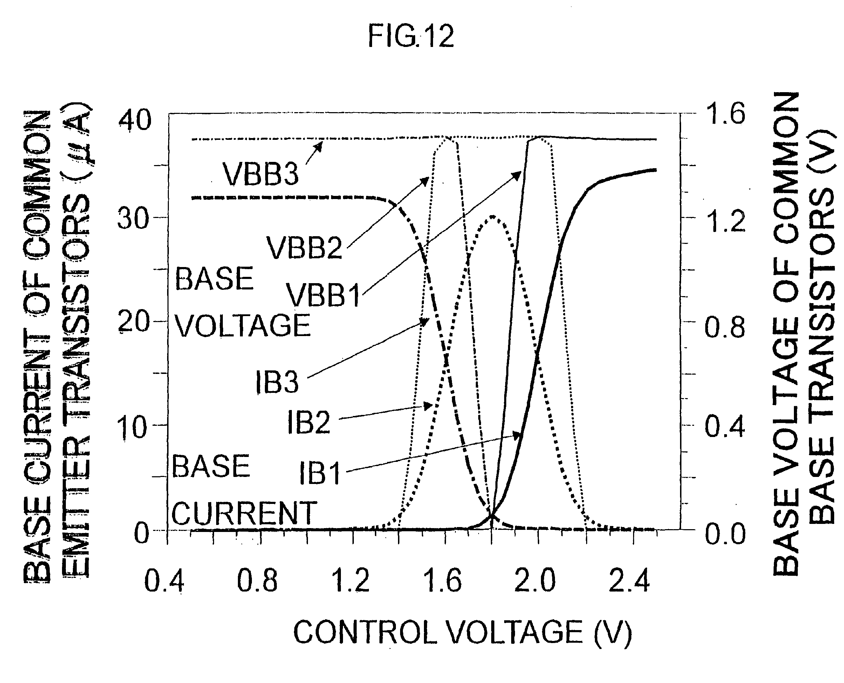

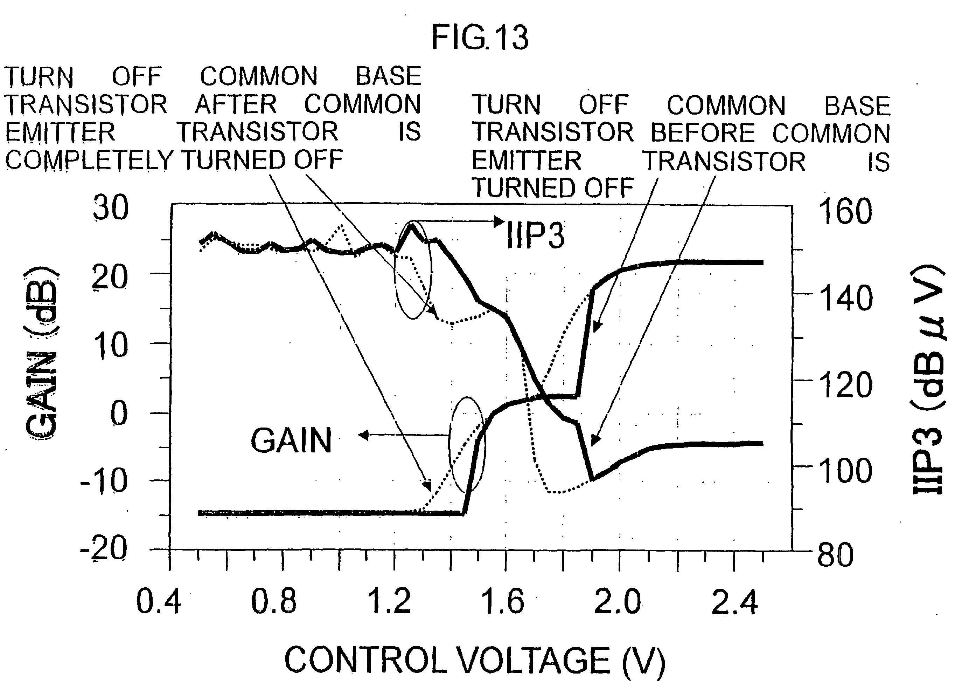

Referring to Figures 12, 13, the following will describe another embodiment of the present invention. Here, for convenience, members of the present embodiment that have the same arrangement and function as members of any one of embodiments 1 to 4, and that are mentioned in that embodiment are indicated by the same reference numerals and description thereof is omitted.

Examining the characteristics of the variable amplifier of embodiment 4 in detail reveals that IIP3 drops with decreasing base currents IB1 to IB3 of the common emitter transistors Q1 to Q3. To improve this characteristic, when the base voltages VBB1 to VBB3 of the common base transistors Q41 to Q43 and the base currents IB1 to IB3 of the common emitter transistors Q1 to Q3 are falling, the variable amplifier of the present embodiment forces the common base transistors off before the base currents IB1 to IB3 of the common emitter transistors Q1 to Q3 fall to such levels where distortion may occur. Characteristics are thus improved.

These switching characteristics are obtained by adjusting, among others, the resistances of the resistors RC1, RC2, RC3 which generate reference voltages in the base voltage control circuit 2 as shown in Figure 10 and the resistances of the resistors R1U, R1L, R2U, R2L, R3U, R3L which carry out current/voltage conversion.

Figure 12 shows the switching characteristics in connection with the base currents IB1 to IB3 of the common emitter transistors Q1 to Q3 and the control voltage VCTRL and also the switching characteristics in connection with the base voltages VBB1 to VBB3 of the common base transistors Q41 to Q43 and the control voltage VCTRL.

Referring to Figure 11, the base voltages VBB1 to VBB3 of the common base transistors Q41 to Q43 are constant throughout a range of control voltage VCTRL where there are non-zero base currents IB1 to IB3 of the common emitter transistors Q1 to Q3. When decreasing the base voltages VBB1 to VBB3 of the common base transistors Q41 to Q43 and the base currents IB1 to IB3 of the common emitter transistors Q1 to Q3, the base currents IB1 to IB3 of the common emitter transistors Q1 to Q3 completely go off (fall almost to 0 V) before the base voltages VBB1 to VBB3 of the common base transistors Q41 to Q43 fall almost to 0 V.

In contrast, in Figure 12, the base voltages VBB1 to VBB3 of the common base transistors Q41 to Q43 fall almost to 0 V, hence go off (cutoff) when the base currents IB1 to IB3 of the common emitter transistors Q1 to Q3 fall to or below about 10% of a predetermined current (predetermined value).

Figure 13 shows the gain and IIP3 characteristics of the variable amplifier of the present embodiment (the gain is controlled only in a common emitter configuration) together with those of the variable amplifier of embodiment 4 (the distortion is removed in a common base configuration) for comparative purposes. It is understood that in the variable amplifier of the present embodiment, IIP3 degradation is greatly eased at a range of control voltage VCTRL at which the transistors Q1 to Q3 are switchable.

As detailed in the foregoing, the variable amplifier of the present embodiment differs from the variable amplifier of embodiment 4 in that the base or gate voltages of the common base or common gate transistors are cut off before the base currents of the common emitter transistors are cut off as a control of the base currents of the common emitter transistors and the base or gate voltages of the common base or common gate transistors. Further, the control eases the development of distortion where the common emitter transistors turn off.

EMBODIMENT 6

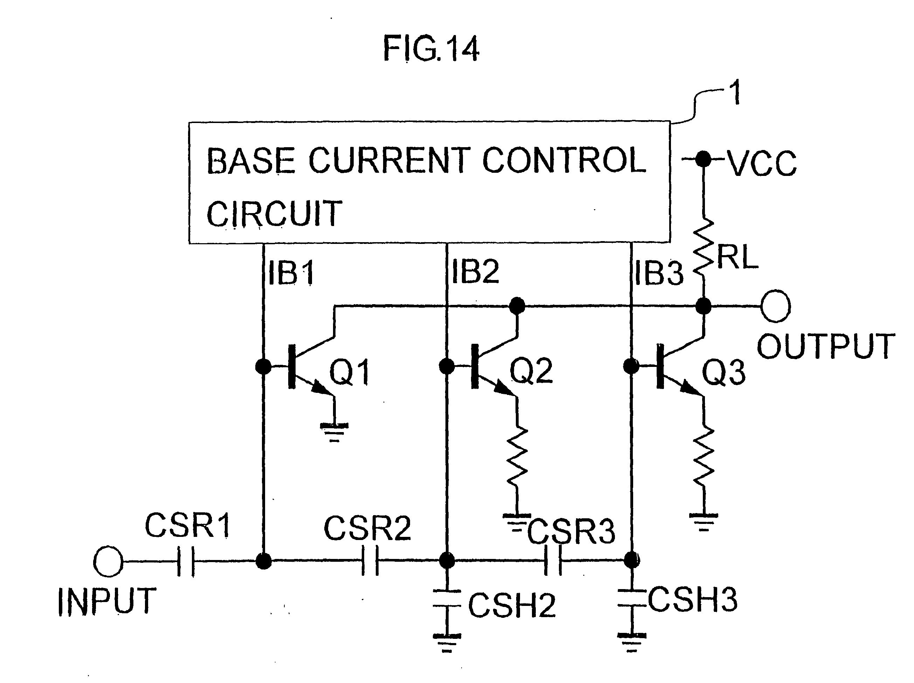

Referring to Figure 14, the following will describe another embodiment of the present invention. Here, for convenience, members of the present embodiment that have the same arrangement and function as members of any one of embodiments 1 to 5, and that are mentioned in that embodiment are indicated by the same reference numerals and description thereof is omitted.

In embodiments 1 to 5 above, all the unit amplifiers (transistors Q1 to Q3) shared identical characteristics (gain and linearity). Individual unit amplifiers may have different characteristics. Achieving a large gain typically necessitates low noise, but not much linearity. A high degree of linearity is required, however, when the signal input has so large an amplitude that the amplifier is set to produce a small gain.

Such characteristics are obtained as follows: No negative feedback is supplied to the amplifier that is the nearest to the input. Negative feedback is supplied to the transistors Q2, Q3 (amplifiers successive to an attenuator) by connecting a resistor or inductor to the emitters of the transistors Q2, Q3 for higher linearity.

As shown in Figure 14, the variable amplifier of the present embodiment differs from the variable amplifier of embodiment 1 in Figure 1 in that a resistor RE2 and a resistor RE3 are inserted respectively between the emitter of the transistor Q2 and ground and between the emitter of the transistor Q3 and ground to realize negative feedback. The transistor Q2 and the resistor RE2 form a unit amplifier, while the transistor Q3 and the resistor RE3 form another unit amplifier.

Alternatively, a capacitor or a resistor between the base and the collector of the transistors Q2, Q3 may be placed to supply negative feedback to the transistors Q2, Q3. Coupling an inductor to an emitter is the best choice in terms of noise characteristics. Coupling a resistor to an emitter is a close second. Placing a resistor or a capacitor between the base and the collector of the transistors Q2, Q3 for negative feedback result in poor noise characteristics.

Increasing current density for the transistors Q2, Q3 is also effective for further linearity improvements. The transistor Q1 that is the nearest to the input needs to have a low base resistance to achieve low noise. To this end, the transistor 1 needs to have relatively large dimensions. To reduce current consumption in the transistor Q1 to a possible minimum, the current density of the transistor Q1 cannot be raised much. However, the specifications of the transistors Q2, Q3 located downstream to the attenuators AT1, AT2 are less strict in terms of noise characteristics. So, linearity is improved by reducing the transistors Q2, Q3 in dimension, hence adding to the current density of the transistors Q2, Q3.

Low noise at large gains and high linearity at small gains are achieved by optimizing the characteristics of the individual unit amplifiers through this or similar approach.

As detailed in the foregoing, the variable amplifier of the present embodiment differs from the variable amplifiers of any one of embodiments 1 through 5 in that the unit amplifiers each containing a transistor include two or more kinds of unit amplifier(s) with different characteristics. In this structure, the amplifier will exhibit greatly improved overall characteristics by optimizing the characteristics of the individual amplifiers in accordance with characteristics.

EMBODIMENT 7

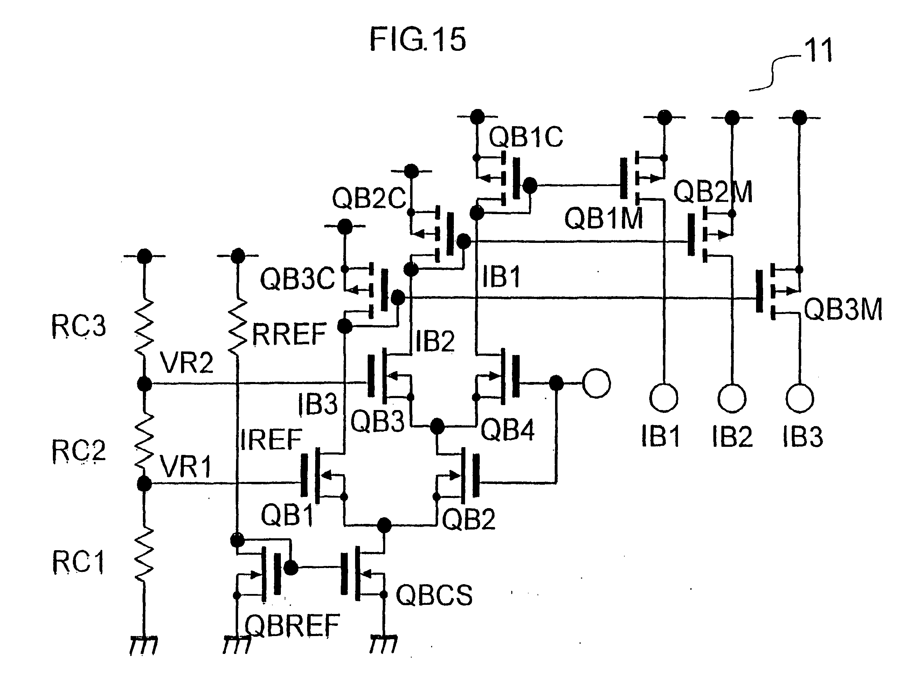

Referring to Figure 15, the following will describe another embodiment of the present invention. Here, for convenience, members of the present embodiment that have the same arrangement and function as members of any one of embodiments 1 to 6, and that are mentioned in that embodiment are indicated by the same reference numerals and description thereof is omitted.

As mentioned earlier, in the variable amplifiers of embodiments 1 to 6, the unit amplifier (transistor Q1) that was the nearest to the input were required to exhibit large gain and low noise. To achieve the latter, reducing the base resistance of the transistor Q1 was inevitable, which in turn meant that the transistor Q1 had to come with added dimensions. To achieve large gain, the transistor Q1 needs to conduct a sufficiently large current. The transistor Q1 had to conduct a sufficiently large current also to achieve a sufficient level of linearity. The current consumption in the first unit amplifier (transistor Q1) therefore was rather large.

In contrast, in the variable amplifiers of embodiments 1 to 6, linearity was an important characteristic for the two unit amplifier sections that were built around the transistors Q2, Q3 to which a signal was fed through the attenuators AT1, AT2. A way of achieving good linearity with these unit amplifier sections is to pass large current through the transistors Q2, Q3. However, in the circuit construction of the variable amplifiers of embodiments 1 to 6, the inputs of the unit amplifier sections were coupled to the attenuators AT1, AT2. This contributed to improvement of IIP3, a linearity indicator. Additionally, the linearity of the unit amplifier sections could be improved by supplying negative feedback to the transistors Q2, Q3 or reducing the transistors Q2, Q3 in emitter area (thus increasing current density) for example. In short, when the noise characteristics are not very important, the linearity of the unit amplifier section can be improved even if the currents through the transistors Q2, Q3 are reduced.

The variable amplifier of the present embodiment differs from the variable amplifier of embodiment 6 in Figure 14 primarily in that the base current control circuit 1 in Figure 2 is replaced with the base current control circuit 11 in Figure 15.

The base current control circuit 11 in Figure 15 differs from the base current control circuit 1 in Figure 2 as follows: The MOS transistor in the current switching section is an n-type field effect transistor (n-channel MOS transistor). A current mirror circuit is provided which contains a p-type field effect transistor (p-channel MOS transistor). The base current control circuit 1 in Figure 2 outputs current directly from the current switching section. In contrast, in the base voltage control circuit 2 in Figure 15, the current switching section controls the incoming current flow, and the current mirror circuit changes the direction in which the current flows. A mirror circuit made up of a transistor QB3C and a transistor QB3M is coupled to the drain of the transistor QB1. Another mirror circuit made up of a transistor QB2C and a transistor QB2M is coupled to the drain of the transistor QB3. Another mirror circuit made up of a transistor QB1C and a transistor QB1M is coupled to the drain of the transistor QB4. The transistors QB1C, QB1M, QB2C, QB2M, QB3C, QB3M are all p-type field effect transistors (p-channel MOS transistors).

Unlike the base current control circuit 1 in Figure 1 where the base current sum is held constant, the base current control circuit 11 in Figure 15 permits free adjustment of individual base currents IB1 to IB3 through the transistors Q1 to Q3 by regulating the gate width of the transistors QB1M, QB2M, QB3M. The base current control circuit 11 controls the base currents IB1 to IB3 so that the combined current consumption in the transistors Q1 to Q3 changes in accordance with the ratio of the base currents IB1 to IB3 through the transistors Q1 to Q3.

For example, IIP3 is substantially in proportion to the collector current. Therefore, provided that the addition of the emitter resistors RE2, RE3 in Figure 14 to the variable amplifier in Figure 1 improves IIP3 by 3 dB while maintaining the collector currents, IIP3 remains substantially unchanged when the collector currents of the transistors Q2, Q3 is reduced to half in the variable amplifier in Figure 1. Therefore, in this case, for example, the base currents IB1, IB3 through the transistors Q1, Q3 should be controlled so that the collector current of the transistor Q3 has a maximum value half that of the collector current of the transistor Q1. These specifications allows some current consumption in the transistors Q1 to Q3 when the input power is small, but a high level of sensitivity is needed, in other words, when the ratio of the base current IB1 to the base current IB3 is high. The specifications also enable further reductions in the current consumption in the transistors Q1 to Q3 when the input power is high, in other words, when the ratio of the base current IB1 to the base current IB3 is low. In this case, when the base current IB1 accounts for, for example, 100% of the base current sum, the current consumption in the transistors Q1 to Q3 does not differ significantly from the variable amplifier in Figure 1. When the base current IB3 accounts for 100% of the base current sum, the current consumption is half that in the variable amplifier in Figure 1.

Conversely, the current consumption may be reduced in a variable amplifier when the input power is small, and raised relatively high when the input power is large and a high IIP3 is needed. This is applicable when that variable amplifier is used in a device of which the wiring design requires neither high IIP3 nor large gain when the input power is small, but requires high IIP3 when the input power is large.

The present embodiment utilizes the simplest common emitter circuits equivalent to those in embodiment 1. The embodiment will exhibit further improvements in characteristics through cascade connections and modifications to the base voltage control circuit as in embodiments 2 to 5.

In the conventional circuits in ISSCC Digest and the Technical Report cannot adjust power consumption in accordance with performance, because switching control and current sum determination are carried out by two individual circuits.

As in the foregoing, the variable amplifier of the present embodiment differs from the variable amplifier in any one of embodiments 1 through 6 in that the current consumption (collector current) in the first group of transistors differs from one transistor to another. The structure enables adjustment of current consumption in accordance with characteristics. The overall current consumption of the amplifier is thus reduced.

EMBODIMENT 8

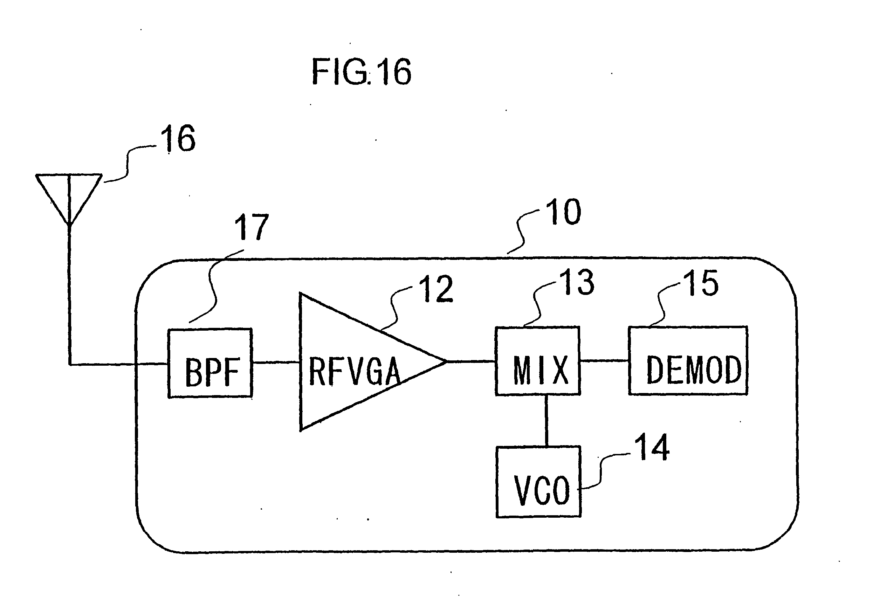

Referring to Figure 16, the following will describe another embodiment of the present invention. Here, for convenience, members of the present embodiment that have the same arrangement and function as members of any one of embodiments 1 to 7, and that are mentioned in that embodiment are indicated by the same reference numerals and description thereof is omitted.

Figure 16 is a block diagram of a mobile wireless terminal (e.g., mobile phone) containing a variable amplifier described in the preceding embodiments as a radio frequency variable gain amplifier (RFVGA). A mobile wireless terminal 10 of the present embodiment, as shown in Figure 16, contains: an antenna 16; a bandpass filter (BPF) 17 limiting the bandwidth of the incoming radio frequency signal received by the antenna 16; a radio frequency variable gain amplifier (RFVGA) 12 amplifying the radio frequency signal filtered by the bandpass filter 17; a mixer (MIX) 13 mixing the radio frequency signal amplified by the radio frequency variable gain amplifier 12 with the oscillating signal output of the voltage control oscillator (VCO) 14 to convert the amplified radio frequency signal to a baseband signal; and a demodulator (DEMOD) 15 demodulating the baseband signal to recover the original signal. The radio frequency variable gain amplifier 12 is any one of the variable amplifiers of embodiments 1 to 7.

Due to the use of the radio frequency variable gain amplifier 12 in accordance with the present invention as the radio frequency variable gain amplifier, the mobile wireless terminal 10 of such a construction is capable of directly coupling the bandpass filter (BPF) 17 to the input of the radio frequency variable gain amplifier, no longer requiring a balun which would be necessary in mobile wireless terminals based on conventional differential amplifier circuitry. The elimination of the balun not only contributes to the overall circuit downsizing in the mobile wireless terminal, but also to reception power savings by eliminating the power dissipation in the balun. Therefore, the use of the radio frequency variable gain amplifier 12 in accordance with the present invention realizes a compact, high sensitivity mobile wireless terminal 10.

Further, the radio frequency variable gain amplifier 12 in accordance with the present invention can optimize the relationship between the gain and the current consumption in accordance with the characteristics of the mobile wireless terminal; thus, the resultant mobile wireless terminal consumes less power, allowing an extended time of operation.

The variable amplifier in accordance with the present invention may be used as an amplifier for the received signal in mobile wireless terminals. Further, the variable amplifier in accordance with the present invention may be used in terminals for the wireless communications system operating with high frequency signals, such as mobile phones.

The invention being thus described, it will be obvious that the same way may be varied in many ways. Such variations are not to be regarded as a departure from the scope of the invention, and all such modifications as would be obvious to one skilled in the art are intended to be included within the scope of the following claims.

**Claims**

**1.** A variable amplifier, comprising:

- unit amplifiers (Q1, Q2, Q3) coupled in parallel between an input signal terminal (INPUT) and an output signal terminal (OUTPUT),
- wherein each unit amplifier comprises a first bipolar transistor in a non-differential common emitter configuration and provides a respective signal path from the input signal terminal to the output signal terminal,
- a base current control section controlling base currents of said first bipolar transistors so that the characteristic of the signal path of a first unit amplifier (Q1) differs from the characteristic of the signal path of another unit amplifier (Q2),

**characterized in that**

- an attenuator (CSR2, CSH2; RSR2, RSH2) through which the input signal terminal (INPUT) and the input of said first unit amplifier (Q1) are connected to the input of said another unit amplifier (Q2).

**2.** The variable amplifier as set forth in claim 1, wherein said transistors have collectors substantially connected to a single load.

**3.** The variable amplifier as set forth in claim 1, further comprising a secondary transistor (Q4) having an emitter or a source substantially connected to the collectors of the transistors (Q3), the secondary transistor (Q4) having a base or a gate grounded in terms of high frequency components and a collector or a drain substantially connected to a load.

**4.** The variable amplifier as set forth in claim 3, wherein two or more of said secondary transistors (Q41, Q42, Q43) are provided, each having an emitter or a source connected to a different one of the collectors of the transistor (Q1, Q2, Q3) of the unit amplifiers.

**5.** The variable amplifier as set forth in claim 4, further comprising a voltage control section (2) controlling base voltages or gate voltages of the secondary transistors (Q41, Q42, Q43).

**6.** The variable amplifier as set forth in claim 5, wherein the voltage control section (2) allows substantially zero base voltages or gate voltages for the secondary transistors (Q41, Q42, Q43) when the base currents of the transistors are below or equal to a predetermined level.

**7.** The variable amplifier as set forth in claim 1, wherein the signal input terminal (INPUT) receives a single-ended signal.

8. The variable amplifier as set forth in claim 1, wherein the characteristic in which one of the paths differs from others is selected from the group consisting of signal amplifying gain, linearity, and noise performance.

9. The variable amplifier as set forth in claim 1, wherein the paths include first signal paths and a second signal path which amplifies a signal at a smaller signal amplifying gain and higher linearity than the first signal paths.

10. The variable amplifier as set forth in claim 9, wherein there is provided a negative feedback to one of the transistors which forms the second signal path, and no negative feedback to other transistors which form the first signal paths, so that the second signal path has higher linearity than the first signal paths.

11. The variable amplifier as set forth in claim 9, wherein one of the transistors which forms the second signal path is smaller in size, hence greater in current density, than other transistors which form the first signal paths, so that the second signal path exhibits higher linearity than the first signal paths.

12. The variable amplifier as set forth in claim 1, wherein the base current control section (1) controls the base currents of the transistors so that a combined current consumption in the transistors varies in accordance with a change in a ratio of the base currents of the transistors.

13. A mobile wireless terminal, comprising an amplifier amplifying a received signal, the amplifier being the variable amplifier as set forth in any one of claims 1 through 12.


**Patentansprüche**

1. Variabler Verstärker, mit:

- Einheitsverstärkern (Q1, Q2, Q3), die zwischen einem Eingangssignalanschluss (INPUT) und einem Ausgangssignalanschluss (OUTPUT) parallelgeschaltet sind,
- wobei jeder Einheitsverstärker einen ersten Bipolartransistor in einer nicht differentiellen Emitterkonfiguration enthält und einen entsprechenden Signalweg von dem Eingangssignalanschluss zu dem Ausgangssignalanschluss schafft, und
- einem Basis-Strom-Steuerabschnitt, der Basis-Ströme der ersten Bipolartransistoren so steuert, dass die Charakteristik des Signalwegs eines ersten Einheitsverstärkers (Q1) von der Charakteristik des Signalwegs eines weiteren Einheitsverstärkers (Q2) verschieden ist,
**gekennzeichnet durch**
- einen Dämpfer (CSR2, CSH2; RSR2, RSH2), **durch** den der Eingangssignalanschluss (INPUT) und der Eingang des ersten Einheitsverstärkers (Q1) mit dem Eingang des weiteren Einheitsverstärkers (Q2) verbunden sind.

2. Variabler Verstärker nach Anspruch 1, wobei die Transistoren Kollektoren besitzen, die im Wesentlichen mit einer einzigen Last verbunden sind.

3. Variabler Verstärker nach Anspruch 1, ferner mit einem sekundären Transistor (Q4), dessen Emitter oder dessen Source im Wesentlichen mit den Kollektoren der Transistoren (Q3) verbunden ist, wobei der sekundäre Transistor (Q4) eine Basis oder ein Gate besitzt, die bzw. das für Hochfrequenzkomponenten geerdet ist, und einen Kollektor oder einen Drain besitzt, der im Wesentlichen mit einer Last verbunden ist.

4. Variabler Verstärker nach Anspruch 3, wobei zwei oder mehr der sekundären Transistoren (Q41, Q42, Q43) vorgesehen sind, wovon jeder mit einem Emitter oder einer Source mit einem anderen der Kollektoren des Transistors (Q1, Q2, Q3) der Einheitsverstärker verbunden ist.

5. Variabler Verstärker nach Anspruch 4, ferner mit einem Spannungssteuerabschnitt (2), der Basis-Spannungen oder Gate-Spannungen der sekundären Transistoren (Q41, Q42, Q43) steuert.

6. Variabler Verstärker nach Anspruch 5, wobei der Spannungssteuerabschnitt (2) Basis-Spannungen oder Gate-Spannungen für die sekundären Transistoren (Q41, Q42, Q43) von im Wesentlichen Null zulässt, wenn die Basis-Ströme der Transistoren niedriger oder gleich einem vorgegebenen Pegel sind.

**7.** Variabler Verstärker nach Anspruch 1, wobei der Signaleingangsanschluss (INPUT) ein Eintaktsignal empfängt.

**8.** Variabler Verstärker nach Anspruch 1, wobei die Charakteristik, in der sich einer der Wege von den anderen unterscheidet, aus der Gruppe ausgewählt ist, die aus einem Signalverstärkungsfaktor, der Linearität und dem Rauschverhalten besteht.

**9.** Variabler Verstärker nach Anspruch 1, wobei die Wege erste Signalwege und einen zweiten Signalweg, der ein Signal mit einem kleineren Signalverstärkungsfaktor und einer höheren Linearität als die ersten Signalwege verstärkt, enthalten.

**10.** Variabler Verstärker nach Anspruch 9, wobei für einen der Transistoren, der den zweiten Signalweg bildet, eine negative Rückkopplung vorgesehen ist, und für die anderen Transistoren, die die ersten Signalwege bilden, keine negative Rückkopplung vorgesehen ist, so dass der zweite Signalweg eine höhere Linearität als die ersten Signalwege hat.

**11.** Variabler Verstärker nach Anspruch 9, wobei einer der Transistoren, der den zweiten Signalweg bildet, eine geringere Größe und daher eine höhere Stromdichte als andere Transistoren, die die ersten Signalwege bilden, hat, so dass der zweite Signalweg eine höhere Linearität als die ersten Signalwege zeigt.

**12.** Variabler Verstärker nach Anspruch 1, wobei der Basis-Strom-Steuerabschnitt (1) die Basis-Ströme der Transistoren steuert, so dass sich ein kombinierter Stromverbrauch in den Transistoren entsprechend einer Änderung des Verhältnisses der Basis-Ströme der Transistoren ändert.

**13.** Mobiles drahtloses Endgerät, das einen Verstärker enthält, der ein empfangenes Signal verstärkt, wobei der Verstärker der variable Verstärker nach einem der Ansprüche 1 bis 12 ist.

**Revendications**

**1.** Amplificateur variable, comprenant :

des amplificateurs d'unité (Q1, Q2, Q3) couplés en parallèle entre un terminal de signal d'entrée (ENTREE) et un terminal de signal de sortie (SORTIE),
dans lequel chaque amplificateur d'unité comprend un premier transistor bipolaire suivant une configuration à émetteur commun non différentiel et fournit un chemin de signaux respectif depuis le terminal de signal d'entrée jusqu'au terminal de signal de sortie,
une section de contrôle de courant de base contrôlant les courants de base desdits premiers transistors bipolaires de telle sorte que la caractéristique du chemin de signaux d'un premier amplificateur d'unité (Q1) diffère de la caractéristique du chemin de signaux d'un autre amplificateur d'unité (Q2),
**caractérisé en ce qu'**il comprend
un atténuateur (CSR2, CSH2 ; RSR2, RSH2) au moyen duquel le terminal de signal d'entrée (ENTREE) et l'entrée dudit premier amplificateur d'unité (Q1) sont connectés à l'entrée dudit autre amplificateur d'unité (Q2).

**2.** Amplificateur variable selon la revendication 1, dans lequel lesdits transistors ont des collecteurs sensiblement connectés à une charge unique.

**3.** Amplificateur variable selon la revendication 1, comprenant en outre un transistor secondaire (Q4) ayant un émetteur ou une source sensiblement connecté aux collecteurs des transistors (Q3), le transistor secondaire (Q4) ayant une base ou une porte logique mise à la terre en termes de composants de haute fréquence et un collecteur ou un drain sensiblement connecté à une charge.

**4.** Amplificateur variable selon la revendication 3, dans lequel deux desdits transistors secondaires (Q41, Q42, Q43) ou plus sont prévus, chacun ayant un émetteur ou une source connecté à un collecteur différent parmi les collecteurs du transistor (Q1, Q2, Q3) des amplificateurs d'unité.

**5.** Amplificateur variable selon la revendication 4, comprenant en outre une section de contrôle de tension (2) contrôlant des tensions de base ou des tensions de porte logique des transistors secondaires (Q41, Q42, Q43).

**6.** Amplificateur variable selon la revendication 5, dans lequel la section de contrôle de tension (2) permet d'obtenir des tensions de base ou des tensions de porte logique sensiblement égales à zéro pour les transistors secondaires (Q41, Q42, Q43) lorsque les courants de base des transistors sont inférieurs ou égaux à un niveau prédéterminé.

**7.** Amplificateur variable selon la revendication 1, dans lequel le terminal de signal d'entrée (ENTREE) reçoit un signal asymétrique.

**8.** Amplificateur variable selon la revendication 1, dans lequel la caractéristique selon laquelle un des chemins diffère des autres est choisie dans le groupe comprenant le gain d'amplification de signal, la linéarité et les performances en bruit.

**9.** Amplificateur variable selon la revendication 1, dans lequel les chemins comprennent des premiers chemins de signaux et un second chemin de signaux qui amplifie un signal suivant un gain d'amplification de signal plus petit et une linéarité plus élevée que les premiers chemins de signaux.

**10.** Amplificateur variable selon la revendication 9, dans lequel il est fourni une contre-réaction à l'un des transistors qui forme le second chemin de signaux et aucune contre-réaction aux autres transistors qui forment les premiers chemins de signaux, de telle sorte que le second chemin de signaux a une linéarité plus élevée que les premiers chemins de signaux.

**11.** Amplificateur variable selon la revendication 9, dans lequel un des transistors qui forme le second chemin de signaux est de taille plus petite, et par conséquent plus grand en termes de densité de courant, que les autres transistors qui forment les premiers chemins de signaux, de telle sorte que le second chemin de signaux présente une linéarité plus élevée que les premiers chemins de signaux.

**12.** Amplificateur variable selon la revendication 1, dans lequel la section de contrôle de courant de base (1) contrôle les courants de base des transistors de telle sorte qu'une consommation de courant combinée dans les transistors varie en fonction d'un changement d'un rapport des courants de base des transistors.

**13.** Terminal mobile sans fil, comprenant un amplificateur amplifiant un signal reçu, l'amplificateur étant l'amplificateur variable selon l'une quelconque des revendications 1 à 12.

FIG.1

FIG.2

FIG.3

FIG.4

FIG.5

EP 1 528 667 B1

# FIG.6

EP 1 528 667 B1

FIG.7

# FIG.8

BASE CURRENT CONTROL CIRCUIT — 1

VCC

RL

VBB1  VBB2  VBB3

OUTPUT

IB1  Q41  IB2  Q42  IB3  Q43

Q1  Q2  Q3

CSR1

CSR2  CSR3

INPUT

CSH2  CSH3

AT1  AT2

EP 1 528 667 B1

# FIG.9

SEPARATED COMMON BASE CONFIGURATION

SINGLE COMMON BASE CONFIGURATION

IIP3

GAIN

GAIN (dB)

IIP3 (dBμV)

CONTROL VOLTAGE (V)

EP 1 528 667 B1

FIG.10

EP 1 528 667 B1

## FIG.11

FIG.12

EP 1 528 667 B1

## FIG.13

TURN OFF COMMON BASE
TRANSISTOR AFTER COMMON
EMITTER TRANSISTOR IS
COMPLETELY TURNED OFF

TURN OFF COMMON BASE
TRANSISTOR BEFORE COMMON
EMITTER TRANSISTOR IS
TURNED OFF

EP 1 528 667 B1

## FIG.14

EP 1 528 667 B1

# FIG.15

EP 1 528 667 B1

EP 1 528 667 B1

FIG.16

33

## REFERENCES CITED IN THE DESCRIPTION

**Patent documents cited in the description**

- JP 2002252532 A

- US 20020113656 A1

**Non-patent literature cited in the description**

- A Low-Noise Wideband Variable-Gain Amplifier Using an Interpolated Ladder Attenuator. *ISSCC Digest of Technical Papers,* February 1991, 280-281

- ISSCC Digest. *Technical Report of Signal Science,* 1997, vol. 96 (462), 9-14